(19) Europäisches Patentamt
European Patent Office
Office européen des brevets

(11) **EP 4 707 717 A2**

(12) **EUROPÄISCHE PATENTANMELDUNG**

(43) Veröffentlichungstag:
**11.03.2026  Patentblatt 2026/11**

(21) Anmeldenummer: **25221922.5**

(22) Anmeldetag: **25.02.2022**

(51) Internationale Patentklassifikation (IPC):
**F41A 19/01** *(2006.01)*

(52) Gemeinsame Patentklassifikation (CPC):
**F41A 19/01**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.02.2021  DE 102021104517**

(62) Dokumentnummer(n) der früheren Anmeldung(en) nach Art. 76 EPÜ:
**24151898.4 / 4 328 536**
**22158688.6 / 4 050 297**

(71) Anmelder: **Heckler & Koch GmbH**
**78727 Oberndorf/Neckar (DE)**

(72) Erfinder:
• **STAIGER, Markus**
**72189 Vöhringen (DE)**

• **SCHEUERMANN, Mark**
**45739 Oer-Erkenschwick (DE)**
• **KOPF, Johannes Alexander**
**78655 Dunningen (DE)**
• **GEBERT, Dietrich**
**72202 Nagold (DE)**
• **RIMPF, Dieter**
**71522 Backnang (DE)**

(74) Vertreter: **Samson & Partner Patentanwälte mbB**
**Widenmayerstraße 6**
**80538 München (DE)**

Bemerkungen:
Diese Anmeldung ist am 09-12-2025 als Teilanmeldung zu der unter INID-Code 62 erwähnten Anmeldung eingereicht worden.

(54) **SCHUSSWAFFENANALYSEVORRICHTUNG**

(57)    Eine Schusswaffenanalysevorrichtung zur Bestimmung des Feuermodus einer Schusswaffe (7) wird beschrieben. Die Vorrichtung umfasst eine Spannungserzeugungseinheit (401), die während des Vor- und/oder Rücklaufs eines beweglichen Waffenteils (120) eine Wechselspannung (Ue) erzeugt, eine Signalverarbeitungseinheit (410), die die Wechselspannung in elektrische Energie umwandelt und diese in einem Energiespeicher speichert, sowie eine Signalauswerteeinheit (420). Die Signalauswerteeinheit verbleibt während zwei unmittelbar aufeinander folgender Schussabgaben im aktivierten Modus, wenn sie mit einer Mindestversorgungsspannung versorgt wird, und wechselt in einen nicht-aktivierten Modus, wenn die Versorgungsspannung unterschritten wird. Der Feuermodus wird bestimmt, indem überprüft wird, ob die Signalauswerteeinheit im aktivierten Modus bleibt (Dauerfeuer) oder in den nicht-aktivierten Modus wechselt (Einzelfeuer). Die Vorrichtung kann in Schusswaffen integriert werden und ermöglicht eine zuverlässige Unterscheidung zwischen Einzelfeuer und Dauerfeuer.

Fig. 1

## Beschreibung

### Technisches Gebiet

Die Erfindung betrifft eine Schusswaffenanalysevorrichtung zur Bestimmung von für eine Schusswaffe indikativen Parametern aus einer Schussabgabe und ein entsprechendes Schusswaffenanalyseverfahren zur Bestimmung von für eine Schusswaffe indikativen Parametern aus einer Schussabgabe mittels einer solchen Schusswaffenanalysevorrichtung. Die Erfindung umfasst auch eine, eine Schusswaffenanalysevorrichtung umfassende Schusswaffe. Ferner umfasst die Erfindung auch ein Computerprogrammprodukt das computerlesbare Anweisungen zur Ausführung einiger der Verfahrensschritte enthält.

Lagebezeichnungen wie "oben", "unten", "links", "rechts", "vorne", "hinten" usw. beziehen sich in dieser Anmeldung auf eine in normaler Schusshaltung gehaltene Schusswaffe, bei der die Seelenachse horizontal verläuft und die Schussabgabe nach vorne vom Schützen weg erfolgt.

### Stand der Technik

Es ist bekannt, mittels Schusszählern zu erfassen, ob eine Schussabgabe mit einer Schusswaffe erfolgt ist, und die mit einer Schusswaffe abgegebenen Schüsse zu zählen.

Insbesondere sind Schusszähler bekannt, die die Anzahl der abgegebenen Schüsse mittels elektrischer Signale zählen. Die Signale bestehen dabei aus elektrischen Spannungen, die durch eine in der Waffe verbaute Magnet-Spulen-Anordnung bei einer Schussabgabe induziert werden.

US 8,046,946 B2 (Packer Engineering, Inc.) offenbart eine Schusszählervorrichtung für eine Schusswaffe bestehend aus einer spezifischen Magnet-Spulen-Anordnung. Die Spule wird hier von durchgehenden Drahtwicklungen gebildet, welche auf nichtmagnetisierbaren Elementen eine Umkehrschlaufe aufweisen, wodurch die induzierten Spannungen benachbarter magnetisierbarer Spulenelemente sich addieren. Durch diesen Aufbau kumulieren und addieren sich die durch die überstreichenden beweglichen Stabmagnete induzierten Feldströme zu einem maximalen, gleichgerichteten Gesamtstrom. Das resultierende Signal dient als Grundlage zur Bestimmung der Anzahl abgegebener Schüsse.

EP 3 140 605 B1 (Heckler & Koch GmbH) offenbart einen batterielosen Schusszähler mit einer Magnet-Spulen-Anordnung, bei der beim Rück- und Vorlauf des Verschlusses alternierend gepolte Permanentmagnete eine Spule mit weichmagnetischem Kern überstreichen. Die Spulenwicklung umgibt den weichmagnetischen zinkenförmigen Kern bzw. einen von dessen Zinken. Anders als bei der in der US 8,046,946 B2 (Packer Engineering, Inc.) beschriebenen Spule weist diese keine Umkehrschlaufen auf und es werden hier durch die Verwendung der Zinken keine Spannungen, sondern die Magnetfelder aufaddiert, d.h. die Permanentmagnete erzeugen beim Überstreichen der Spule eine Folge von Spannungsimpulsen mit entgegengesetzt ausgerichteten Spannungsamplituden, also eine (nicht-aufaddierte) Wechselspannung. Dieses Signal ermöglicht es, aufgrund der so gewonnenen zusätzlichen Phaseninformation, neben der Anzahl der abgegebenen Schüsse auch zwischen Vor- und Rücklauf des Verschlusses zu unterscheiden.

Über die von bekannten Schusszählern gewonnene Information zur Schussabgabe einer Schusswaffe kann beispielsweise Rückschluss auf den Verschleiß einer Schusswaffe gezogen werden.

### Aufgabe und Lösung der Erfindung

Es ist eine Aufgabe der vorliegenden Erfindung die Diagnose von Schusswaffen zu verbessern, insbesondere eine weitergehende Analyse der Schussabgabe über das reine Zählen der Schüsse hinaus zu ermöglichen.

Die Erfindung löst diese Aufgabe mit jedem der Gegenstände der Ansprüche 1, 11 und 13.

Ein Aspekt der Erfindung betrifft eine Schusswaffenanalysevorrichtung zur Bestimmung von für eine Schusswaffe indikativen/charakteristischen Parametern aus einer Schussabgabe.

Bei der Schusswaffenanalysevorrichtung kann es sich auch um eine Schusswaffendiagnosevorrichtung handeln.

Die Schusswaffenanalysevorrichtung umfasst z.B. eine Spannungserzeugungseinheit, eine Signalverarbeitungseinheit, eine Signalauswerteeinheit und eine Zeitbestimmungseinheit.

Die Spannungserzeugungseinheit erzeugt dabei beim durch eine Schussabgabe versursachten Rück- und Vorlauf z.B. des Schlittens ein Wechselspannungssignal. Dieses wird ggf. in der Signalverarbeitungseinheit zu einem verwendbaren Messsignal vorverarbeitet, z.B. durch einen Analog-Digital-Konverter (ADC) oder eine Gleichrichterschaltung. Die Signalauswerteeinheit analysiert das Messsignal und bestimmt daraus Informationen über die Waffe und/oder Schussabgabe. Dazu greift sie ggf. auf Zeitinformationen wie Zeitdauern zurück, die in der Zeitbestimmungseinheit ermittelt wurden.

Die Spannungserzeugungseinheit ist dabei dazu ausgelegt, während eines bei einer Schussabgabe erfolgenden Vor- und/oder Rücklaufs eines beweglichen Waffenteils, z.B. des Schlittens einer Pistole, eine Wechselspannung zu erzeugen. Die Erzeugung der Spannung kann dabei entlang eines Teilabschnitts der Strecke erfolgen, die der bewegliche Waffenteil beim Rück- oder Vorlauf zurücklegt. Die Spannungserzeugung kann mittels einer Magnet-Spulen-Anordnung, wie sie z.B. in US 8,046,946 B2 (Packer Engineering, Inc.) oder in EP 3 140 605 B1 (Heckler & Koch GmbH) beschrieben wird, erfolgen. Für die Schussanalyse- bzw. Schusswaffenanalysevorrichtung der vorliegenden Erfindung können also die aus EP 3 140 605 B1 bekannten induktiv erzeugten Wechselspannungssignale verwendet werden. Eine Verwendung dieser Signale hat den Vorteil, dass keine neuen, zusätzlichen Basissignale erzeugt werden müssen und zur Spannungserzeugung auf für Schusswaffen bekannte Bauelemente zurückgegriffen werden kann. Es sind aber auch anders erzeugte Wechselspannungssignale, z.B. über Piezoelemente oder elektromechanische Wandler erzeugte, denkbar. Unabhängig von der Art ihrer Erzeugung dienen die Wechselspannungssignale dann als Eingangssignale der Signalverarbeitungseinheit.

Die Signalverarbeitungseinheit kann dazu verwendet werden, die erzeugte Wechselspannung in ein in den weiteren Vorrichtungskomponenten verwendbares Messsignal umzuwandeln. Z.B. kann das analoge Wechselspannungssignal ohne Vorverarbeitung bereitgestellt werden. Das Messsignal wäre in diesem Fall mit dem Wechselspannungssignal identisch. Alternativ kann es z.B. auch mittels Analog-Digital-Konverter (ADC) digitalisiert werden und als alternative oder zusätzliche Option noch weiter vorverarbeitet werden. Dazu kann die Signalverarbeitungseinheit dazu weitere geeignete Schaltelemente wie Filter, Gleichrichter umfassen.

Gemäß einiger Ausführungsformen wird in der Signalverarbeitungseinheit zusätzlich ein Referenzsignal und/oder eine Versorgungsspannung für die nachgeschaltete Signalauswerteeinheit erzeugt. Das Referenzsignal kann z.B. als dynamischer Vergleichswert für die Analyse des Messsignals verwendet werden. Das Mess- und/oder Referenzsignal wird dann in der nachfolgenden Signalauswerteeinheit ausgewertet.

Die Signalauswerteeinheit kann z.B. einen Microcontroller umfassen. Sie dient allgemein der Auswertung und Analyse von Signalen. Insbesondere kann sie der Bestimmung von Zeitpunkten und Parametern wie Geschwindigkeit, Beschleunigung, Kadenzen/Schussraten oder Feuermodi dienen. Die Signalauswerteeinheit kann z.B. dazu ausgelegt sein, einen ersten und einen zweiten Zeitpunkt während des Vor- und/oder Rücklaufs des beweglichen Waffenteils zu bestimmen. Das können z.B. bestimmte Zeitpunkte im Verlauf des Messsignals sein, wie Anfang und Ende des Signals oder Anfang und Ende einer Periode oder Halbperiode innerhalb eines Signals.

Die Zeitbestimmungs- oder Zeitmesseinheit dient allgemein der Zeitmessung und sie kann ganz allgemein Dauern wie Signaldauern, Dauern von Signal- bzw. Zeitabschnitten oder Abstände zwischen einzelnen Signalen oder Zeitpunkten, die sich innerhalb eines Signals befinden oder auf mehrere Signale verteilt sind, bestimmen. Insbesondere wird sie dazu genutzt, die Zeitabstände zwischen ersten und zweiten Zeitpunkten zu bestimmen. Zeitbestimmungseinheiten können dabei jegliche zur relativen oder absoluten Bestimmung von Dauern geeignete Vorrichtungen sein. Z.B. Uhren, Taktgeber in Kombination mit einem Timer, der die Takte zählt und die Zeitabstände zwischen aufeinanderfolgenden Takten kennt sowie Kondensatoren deren Grad der Entladung als Maß für eine verstrichene Zeit dient.

Mit der beschriebenen Schusswaffenanalysevorrichtung lassen sich eine Vielzahl von Informationen gewinnen, aus denen sich Parameter, wie Geschwindigkeiten und Beschleunigungen des Schlittens/Verschlusses beim Schuss, Feuerraten oder Munitionstypen ableiten lassen. Aus bereits bekannten Signalen können also in vorteilhafter Weise neue zusätzliche Informationen gewonnen werden. Die zusätzlichen Informationen zur Schussabgabe wie Anzahl und Intensität liefern z.B. konkretere Anhaltspunkte für die Abschätzung des Schusswaffenverschleißes. So kann die Wartung von Schusswaffen verbessert und erleichtert und dadurch letztendlich die Sicherheit bei deren Handhabung erhöht werden. Zudem lassen sich solche weiterführenden Informationen zur Dokumentation und Überwachung sowie auch für logistische Zwecke (z.B. Bevorratung von Ersatzteilen und Munition) der Nutzung der Waffe verwenden. Hersteller können solche Daten z.B. bei der Verbesserung und Weiterentwicklung von Waffen heranziehen. Schließlich erleichtern detaillierte Informationen zu mit einer Waffe erfolgten Schussabgaben forensische Untersuchungen.

Ein weiterer Aspekt der Erfindung betrifft eine Schusswaffe, die eine Schusswaffenanalysevorrichtung umfasst.

Ein weiterer Aspekt der Erfindung betrifft ein Verfahren zur Bestimmung von für eine Schusswaffe indikativen Parametern aus einer Schussabgabe.

Das Verfahren kann allgemein zur Bestimmung von Parametern und weiteren Informationen über Schusswaffen und Schussabgaben genutzt werden. Dazu kann es z. B. umfassen: ein Erfassen von Wechselspannungen, ein Bereitstellen wenigstens eines auf der Wechselspannung basierenden Messsignals, ein Bestimmen wenigstens eines ersten und eines zweiten Zeitpunkts des Vor- und/oder Rücklaufs und ein Bestimmen wenigstens einer Zeitabschnittsdauer, d.h. einer Dauer von durch die ersten und zweiten Zeitpunkte definierten Zeitabschnitten.

Das Verfahren kann dabei die Bestandteile der oben beschriebenen Schusswaffenanalysevorrichtung verwenden.

Die Wechselspannungen können während eines bei einer Schussabgabe erfolgenden Vor- bzw. Rücklaufs eines beweglichen Waffenteils erzeugt worden sein; z.B. von der oben beschriebenen Spannungserzeugungseinheit.

Das Messsignal kann basierend auf den erzeugten Wechselspannungen erzeugt werden.

Die ersten und zweiten Zeitpunkte umfassen die oben beschriebenen Beispiele.

Das Bestimmen der Dauern kann z.B. mittels der oben beschriebenen Zeitbestimmungseinheit erfolgen. Während die Erfindung in den unabhängigen Ansprüchen definiert ist, ergeben sich weitere Merkmale bevorzugter Ausführungsbeispiele aus den abhängigen Ansprüchen, den beigefügten Zeichnungen und der nachfolgenden Beschreibung.

Ein weiterer Aspekt der Erfindung betrifft ein Computerprogrammprodukt das computerlesbare Anweisungen zur Ausführung einiger der Verfahrensschritte enthält.

Im Folgenden werden zunächst die Unteransprüche behandelt, woraus sich weitere Merkmale möglicher Ausführungsformen der Erfindung ergeben.

In einer Ausführungsform (Ansprüche 2 und 18) wird aus jeder erzeugten Wechselspannung oder einem darauf basierenden Signal ein Referenzsignal erzeugt; z.B. durch eine Gleichrichterschaltung in der Signalverarbeitungseinheit. Die Erzeugung eines Referenzsignals hat den Vorteil, dass dieses als dynamischer Referenz- oder Schwellwert für das Messignal dienen kann. Dynamisch meint dabei, dass zu jedem Zeitpunkt der Wert für jede Waffe und sogar jedes Signal individuell bestimmt wird. Z. B. kann ein erster Zeitpunkt und ein zweiter Zeitpunkt dann z.B. durch die Signalauswerteeinheit anhand eines Vergleichs des Mess- und des Referenzsignals bestimmt werden; z.B. mittels eines Vergleichs der Zeitverläufe. Es wird dabei ausgenutzt, dass Variationen in der Amplitude des Wechselspannungssignals (z.B. durch Variationen der Abstände zwischen Magnet und Spule oder der Geschwindigkeiten) sowohl die Amplitude des Referenz- als auch des Messignals ändern, dabei jedoch das Verhältnis von Referenz- und Messignal gleichbleiben.

In einer weiteren Ausführungsform (Anspruch 3) kann die Spannungserzeugungseinheit wenigstens zwei magnetische Pole und eine Spule umfassen. Dabei können die wenigstens zwei magnetischen Pole derart nacheinander angeordnet sein, dass sie sich in Reaktion auf eine Schussabgabe auf einer Bahn relativ zur Spule bewegen. Aufeinanderfolgende Pole weisen dabei jeweils zueinander entgegengesetzte Polarisierungen auf. Die Pole können die Spule derart nacheinander passieren, dass sie in der Spule jeweils während eines Rück- bzw. Vorlaufs nacheinander entgegengesetzt gerichtete Spannungen induzieren. Derartige Spannungserzeugungseinheiten sind gut zu fertigen und liefern zuverlässig geeignete Wechselspannungssignale.

In einer weiteren Ausführungsform (Ansprüche 4 und 19) werden die Zeitpunkte danach bestimmt, wann das Messignal das Referenzsignal oder einen davon abgeleiteten Schwellenwert über- oder unterschreitet. Z. B. kann der erste Zeitpunkt danach bestimmt werden, wann das Messignal das Referenzsignal oder einen davon abgeleiteten Schwellenwert über- oder unterschreitet. Ferner kann der zweite Zeitpunkt danach bestimmt werden, wann das Messignal das Referenzsignal oder einen davon abgeleiteter Schwellwert nach dem ersten Zeitpunkt erneut über- oder unterschreitet. Das Referenzsignal dient also als der oben beschriebene dynamische Referenzwert für die Analyse des Messignals. So können die gewünschten Zeitpunkte auf einfache Weise aus dem Verlauf der beiden Signale über die Zeit bestimmt werden. Z.B. kann so auch die Dauer einer Periode des Messignals bestimmt werden. Dies erfolgt z.B. in der Signalauswerteeinheit.

In einer weiteren Ausführungsform (Ansprüche 5 und 20) wird anhand des Messignals und des Referenzsignals die Geschwindigkeit eines beim Rück- und/oder Vorlauf bewegten Teils der Schusswaffe bestimmt. Dazu können der erste Zeitpunkt und der zweite Zeitpunkt während eines einzigen Rücklaufs oder eines einzigen Vorlaufs der beweglichen Waffenteile bestimmt werden. Aus der bestimmten Zeitabschnittsdauer des durch diese beiden Zeitpunkte definierten Zeitabschnitts und einer Länge einer Strecke, entlang der beim Rück- oder Vorlauf die dem Messignal zu Grunde liegende Wechselspannung dieses Zeitabschnitts erzeugt wird, kann die Geschwindigkeit der beweglichen Waffenteile während dieses Zeitabschnitts bestimmt werden. Beispielsweise können über das Messignal dem ersten Zeitpunkt und dem zweiten Zeitpunkt eine entsprechende erste und eine entsprechende zweite Position auf einer Strecke, entlang derer die Spannungserzeugungseinheit die dem Messignal zugrundeliegende Wechselspannung erzeugt, zugeordnet werden. Die Geschwindigkeit bestimmt sich dann aus der Zeitabschnittsdauer und dem Abstand der ersten und der zweiten Position. Die Geschwindigkeitsbestimmung kann z.B. durch die Signalauswerteeinheit erfolgen, wobei die Dauer z.B. von einer der Zeitbestimmungseinheiten bestimmt wird. Auf diese Weise kann für jede Schussabgabe die Geschwindigkeit beispielsweise des Schlittens bestimmt werden, was z.B. für die Überwachung und Wartung der Waffe von Vorteil ist.

In einer weiteren Ausführungsform (Anspruch 21), werden während wenigstens zwei aufeinanderfolgenden Zeitabschnitten die jeweiligen Geschwindigkeiten der beweglichen Waffenteile bestimmt; und die Beschleunigung der beweglichen Waffenteile während deren Rück- oder Vorlauf aus den bestimmten Geschwindigkeiten und einem zeitlichen Abstand zwischen den wenigstens zwei aufeinanderfolgenden Zeitabschnitten bestimmt. So kann auf einfache Weise aus dem bereits vorhandenen Signal zusätzlich die Beschleunigung der bewegten Waffenteile bestimmt werden, was z.B. Rückschlüsse auf die verwendete Munition erlaubt.

In einer weiteren Ausführungsform (Anspruch 6) stellt die Signalverarbeitungseinheit eine auf den Wechselspannungen basierende Versorgungsspannung für den Betrieb der Signalauswerteeinheit bereit. Dadurch kann die gesamte Schusswaffenanalysevorrichtung batterielos betrieben werden.

In einer weiteren Ausführungsform (Ansprüche 7 und 22) wird das Referenzsignal gleichrichtet, z.B. während dessen Erzeugung. Die Signalverarbeitungseinheit umfasst dazu z.B. eine Gleichrichterschaltung zum Gleichrichten von Spannungen. So kann z.B. das Referenzsignal vom Messignal dadurch unterschieden werden, dass es nicht oder nur leicht moduliert ist und/oder nichtperiodisch ist. Ein gleichgerichtetes Referenzsignal kann zudem vorteilshafterweise auch von Signalauswerteinheiten, die nur Gleichströme erfassen können, ausgewertet werden. Dies ist z.B. bei Microcontrollern üblicherweise der Fall. Schließlich kann das gleichgerichtete Referenzsignal auch zur Gleichstromversorgung der Signalauswerteeinheit genutzt werden.

In einer weiteren Ausführungsform (Ansprüche 8 und 23) wird das Messsignal während seiner Erzeugung halbwellengleichrichtet oder nicht-gleichrichtet, z.B. durch die Signalverarbeitungseinheit. Dadurch bleibt es unterscheidbar vom Referenzsignal, z.B. weil es moduliert und/oder nicht-periodisch ist. Zudem enthält es trotzdem die Phaseninformation der erzeugten Wechselspannung. Die Halbwellengleichrichtung kann z.B. durch die zur Gleichrichtung des Referenzsignals verwendete Gleichrichterschaltung oder Teilen davon erfolgen.

In einer weiteren Ausführungsform (Ansprüche 9 und 24) wird das Referenzsignal während seiner Erzeugung zudem aufaddiert. Dazu kann eine spannungsverdoppelnde Schaltung verwendet werden. Z.B. umfasst die Signalverarbeitungseinheit dazu eine Delon-Schaltung als Gleichrichterschaltung. Die Delon-Schaltung wirkt neben dem Gleichrichten auch als Spannungsverdoppler. Somit werden die gleichgerichteten Signale zusätzlich noch verstärkt.

In einer weiteren Ausführungsform umfasst die Zeitbestimmungseinheit einen Timer und eine Taktquelle, wobei der Timer Dauern über eine Anzahl der Takte und einen Zeitabstand zwischen den Takten bestimmt. So können auf einfache und bewährte Weise Zeitabstände und -dauern bestimmt werden.

In einer weiteren Ausführungsform umfasst die Zeitbestimmungseinheit einen mit einer Last verbundenen Kondensator, wobei der Kondensator während eines Rück- und/oder Vorlaufs durch die dabei erzeugte Wechselspannung geladen wird und die Dauern über den Grad der Entladung des Kondensators bestimmt werden. So ist eine Zeitmessung auch bei nicht bestehender Stromversorgung über eine gewisse Zeit möglich.

In einer weiteren Ausführungsform (Ansprüche 10 und 25) wird bestimmt, ob eine Schussabgabe im Einzelfeuer oder im Dauerfeuer erfolgt. Dazu kann z.B. der zeitliche Abstand zwischen einzelnen Schussabgaben bestimmt werden. Z.B., indem der erste Zeitpunkt als das Ende eines bei einem Vorlauf erzeugten Messignals bestimmt wird und der zweite Zeitpunkt als der Anfang eines bei einem, auf diesen Vorlauf folgenden, Rücklauf erzeugten Messignals bestimmt wird. Die Dauern der durch die ersten und zweiten Zeitpunkte definierten Zeitabschnitte bestimmen dann den zeitlichen Abstand zwischen einzelnen Schussabgaben. Anhand der Dauer des durch den ersten Zeitpunkt und den zweiten Zeitpunkt definierten Zeitabschnitts kann dann bestimmt werden, ob eine Schussabgabe im Dauer- oder Einzelfeuer erfolgt ist. Dies kann z.B. in der Signalauswerteeinheit erfolgen. Dabei wird bestimmt, dass Dauerfeuer vorliegt, wenn die Zeitabstandsdauer zwischen den mehreren Vorläufen oder den mehreren Rückläufen beweglicher Waffenteile unterhalb eines Zeit- oder Spannungsgrenzwerts liegen, und sonst, dass Einzelfeuer vorliegt. Als Kriterium dafür, dass Dauerfeuer vorliegt, können noch weitere Bedingungen herangezogen werden, z.B. dass die Schusswaffe im Dauerfeuer abgefeuert werden kann und/oder dass mehrere Vor- und Rückläufe detektiert wurden. Auf diese Weise sind in verlässlicher und einfacher Weise Informationen über die Belastung der Waffe z.B. für die Wartung zugänglich.

In einer weiteren Ausführungsform (Ansprüche 11 und 26) werden anhand des Zeitabstandsgrenzwerts und/oder eines weiteren Zeitabstandsgrenzwerts Zeitabstandsintervalle definiert. Darauf basierend werden wenigstens zwei unterschiedliche Schussraten im Einzelfeuer und/oder im Dauerfeuer bestimmt. Die Bestimmung erfolgt darauf basierend, in welchem dieser Zeitabstandsintervalle die Zeitabstandsdauer liegt. Das alles kann z.B. in der Signalauswerteeinheit erfolgen. Dies hat den Vorteil, dass detailliertere Informationen z.B. für die Wartung zugänglich sind.

In einer weiteren Ausführungsform (Ansprüche 12 und 27) wird das Messsignal digitalisiert. Z.B. kann es in ein binäres Signal umgewandelt werden. Dies kann z.B. durch die Signalauswerteeinheit erfolgen. Bei Vorhandensein eines Referenzsignals kann es z.B. nach folgender Vorschrift in ein digitales Messsignal umgewandelt werden:

$$\text{if (Messignal} \geq \text{Referenzsignal)}$$

$$\text{digitales Messignal} = 1$$

$$\text{elseif (Messignal} \leq U0)$$

$$\text{digitales Messignal} = 0$$

$$\text{else}$$

$$\text{digitales Messignal} = \text{leer}$$

$$\text{wobei } U0 \leq \min \text{(Referenzsignal)}.$$

So kann die Phaseninformation in ein binäres und somit schnell und leicht auslesbares Signal umgewandelt werden, mit dem z.B. Rück- und Vorlauf kodiert werden können. Über das binäre Signal bzw. die daraus entstandene Kodierung kann also die Unterscheidung der Laufrichtung abgeprüft werden.

In einer Ausführungsform (Anspruch 13) kodiert die Spannungserzeugungseinheit die von ihr erzeugte Wechselspannung das bewegliche Waffenteil eindeutig. Z.B. kann sie ein das bewegliche Waffenteil eindeutig identifizierendes Signal erzeugen. Z.B. können bei einer Magnet-Spulen Anordnung die Magnete im beweglichen Waffenteil angeordnet sein und die Anzahl der Magnete indikativ für das bewegliche Waffenteil sein. So können aus dem Signal in einfacher Weise zusätzliche Informationen über die Schussabgabe und die Waffen gewonnen werden.

In einer Ausführungsform (Anspruch 28) wird das digitale Messignal genutzt, um erste und zweite Zeitpunkte zu bestimmen. Z.B. wird ein erster Zeitpunkt danach bestimmt, wann das digitale Messignal von "0" oder "leer" auf "1" wechselt, und ein zweiter Zeitpunkt danach bestimmt, wann das digitale Messignal von "1" oder "leer" auf "0" wechselt. So können die ersten und zweiten Zeitpunkte vorteilhaft auch aus dem digitalen Messignal bestimmt werden.

In einer weiteren Ausführungsform (Ansprüche 14 und 29) wird das digitale Messignal genutzt, um zu bestimmen, ob ein Rück- oder ein Vorlauf erfolgt ist. Z.B. kann anhand der Abfolge von Signalabschnitten, in denen das digitale Messignal ununterbrochen "1" oder "0" ist, bestimmt werden, ob dem Messignal ein Vor- oder ein Rücklauf der beweglichen Waffenteile zu Grunde liegt, z.B. durch die Signalauswerteeinheit. So können auf einfache und zuverlässige Weise zusätzliche Informationen aus dem digitalen Signal gewonnen werden.

Eine weitere Ausführungsform umfasst eine Uhr, um die Uhrzeit und/oder das Datum einer Schussabgabe zu bestimmen. So kann z.B. ein Logbuch mit Datum und Uhrzeit der Waffennutzung und der daraus gewonnenen Daten geführt werden.

Eine weitere Ausführungsform (Anspruch 15) umfasst einen Beschleunigungssensor mittels dem die Beschleunigung des Vor- und/oder Rücklaufs der beweglichen Waffenteile bestimmt werden kann. So kann auf einfache und bewährte Weise die Beschleunigung der bewegten Waffenteile bestimmt werden, was z.B. Rückschlüsse auf die verwendete Munition erlaubt.

Nachfolgend werden Ausführungsbeispiele der Erfindung anhand der beigefügten schematischen Zeichnungen erläutert.

In den Zeichnungen zeigt:

FIG. 1          einen Teil einer Schusswaffe mit einer Spannungserzeugungseinheit;

FIG. 2a          ein vollständiges Spannungssignal an der Induktionsspule bei einer Bewegung des Verschlussschlittens der Schusswaffe mit der Spannungserzeugungseinheit nach hinten;

FIG. 2b          ein vollständiges Spannungssignal an der Induktionsspule bei einer Bewegung des Verschlussschlittens der Schusswaffe mit der Spannungserzeugungseinheit nach vorn;

FIG. 2c          einen Spannungsverlauf mit einem vollständigen Signal an der Induktionsspule beim Schießen der Schusswaffe mit der Spannungserzeugungseinheit mit einem Verschlussrücklaufssignal und einem Verschlussvorlaufssignal;

FIG. 3a - 3d          Anordnungen von Magneten und Spulen zur Erzeugung der verwendbaren Spannungen;

FIG. 4          eine Schaltung zur Erzeugung, Verarbeitung und Auswertung der Signale;

FIG. 5          eine Schaltung zur Erzeugung, Verarbeitung und Auswertung der Signale, bei der zur Signalverarbeitung eine Delon-Schaltung verwendet wird;

FIG. 6          eine Delon-Schaltung;

FIG. 7          Verläufe eines Mess- und eines Referenzsignals sowie Beispiele für erste und zweite Zeitpunkte und die Digitalisierung des Messsignals;

FIG. 8a und 8b          die Eindeutigkeit des digitalen Messignals.

Alle Figuren verwenden für gleiche oder gleichartige Elemente durchgehend gleiche Bezugszeichen. Erläuterungen einer Figur beziehen sich sinngemäß auch auf die jeweils anderen Figuren.

Die im Folgenden beschriebenen Schusswaffenanalysevorrichtungen sind grundsätzlich zum Analysieren und Zählen von Schüssen und anderen Bewegungen von Waffenteilen geeignet. Beispielsweise können auch Verschlussbewegungen beim manuellen Durchladen oder Entladen einer Schusswaffe erfasst, analysiert und, falls erwünscht, gezählt werden.

Beim Analysieren werden für die Schusswaffe indikative Parameter bestimmt, insbesondere für eine Bewegung von Teilen der Schusswaffe. Dies umfasst z.B. Parameter wie Anzahl der Schüsse, Uhrzeit und Datum der Schussabgabe, Dauer der Schussabgabe sowie Geschwindigkeit, Beschleunigung und Zeitabstände von Bewegungen von Waffenteilen. Ferner können Kadenzen und Feuermodi (Dauerfeuer, Einzelfeuer) bestimmt werden.

Bei den Schusswaffen kann es sich z.B. um Kurz- oder Langwaffen handeln. Im Rahmen der folgenden Erläuterungen dienen Verschlüsse und Schlitten als Beispiele für sich beim Schuss bewegende Waffenteile und Griffstücke oder Waffengehäuseelemente als Beispiele für stationäre Waffenteile. Grundsätzlich können alle Waffenteile, die sich bei einer Schussabgabe relativ zueinander bewegen zur Signalerzeugung genutzt werden. Insbesondere umfasst dies einerseits Teile, die sich beim Durchladen oder einem sonstigen vergleichbaren Ereignis bewegen und auf der anderen Seite Teile die relativ zu diesen stationär bleiben. Die ermittelten Parameter liefern insofern auch spezifische Informationen zu den jeweiligen beweglichen Waffenteilen und die Schusswaffenanalysevorrichtungen können somit auch als Sensor für Daten über die entsprechenden Waffenteile, z.B. den Schlitten, dienen.

In den beschriebenen Ausführungsformen kann die Spannungserzeugungseinheit alternierend gepolte Permanentmagnete besitzen, welche, in einer Reihe in einem beweglichen Teil der Schusswaffe angeordnet sind, beispielsweise im Schlitten oder Verschluss der Schusswaffe. So bewegen sich bei einem Vor- oder Rücklauf des beweglichen Teils die Permanentmagnete mit ihren alternierenden Polenden auf einer Bahn relativ zu einer stationären, beispielsweise im Griffstück der Schusswaffe angeordneten, Spule mit weichmagnetischem Kern. Die Permanentmagnete passieren die Spule nacheinander und induzieren so auf Grund der alternierenden Polung ein Wechselspannungssignal.

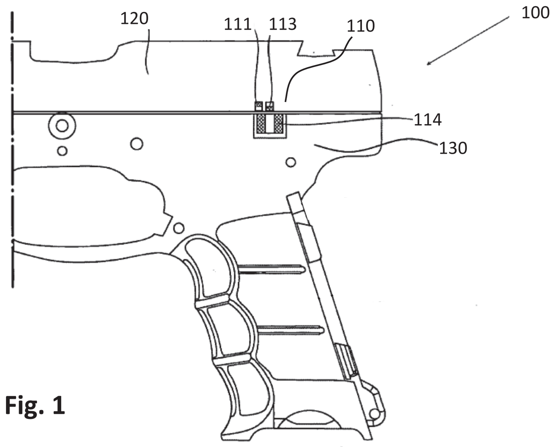

Anhand des Beispiels eines in EP 3 140 605 B1 (Heckler & Koch GmbH) beschriebenen und in FIG.1 gezeigten Schusszählers soll zunächst ein Beispiel für eine mögliche Ausführungsform einer Spannungserzeugungseinheit erläutert werden.

Die dort gezeigte Spannungserzeugungseinheit 110 umfasst dabei also z.B. einen ersten magnetischen Pol 113, einen zweiten magnetischen Pol 111 und eine Spule 114. Dabei sind der erste und der zweite magnetische Pol 111, 113 derart nacheinander angeordnet, dass sie zueinander entgegengesetzte Polarisierungen aufweisen und sie sich in Reaktion auf eine Schussabgabe auf einer Bahn relativ zur Spule 114 bewegen. Sie passieren dabei die Spule derart nacheinander, dass sie in der Spule jeweils während eines Rück- bzw. Vorlaufs nacheinander Spannungen mit entgegengesetzt gerichtetem Vorzeichen induzieren. Der erste und zweite magnetische Pol 113, 111 sind hier im Schlitten 120 der Schusswaffe 100 angeordnet. Im Griffstück 130 sind der weichmagnetische Kern und die Spule 114 angeordnet. Der weichmagnetische Kern ist dreizinkig ausgestaltet und die Spule 114 um die mittlere Zinke gewickelt.

Ganz allgemein ist jede Anordnung aus zwei oder mehr alternierend gepolten Permanentmagneten geeignet. Insbesondere kann die Anordnung aus einer geradzahligen Anzahl von 2N Permanentmagneten bestehen. Auch können mehr als eine Spule vorhanden sein und die Spule/Spulen andere Formen aufweisen.

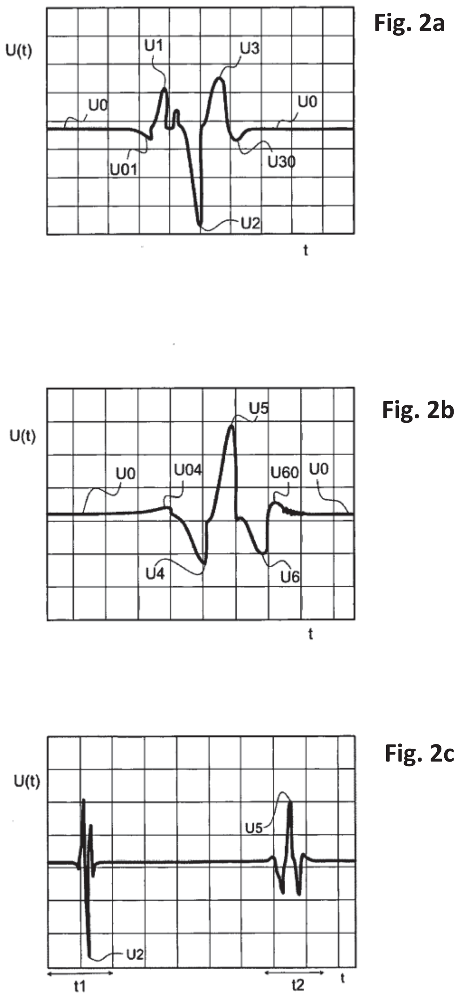

Durch eine geradzahlige Anordnung der Permanentmagneten werden beim Vor- und Rücklauf des Schlittens zwei unterschiedliche Spannungsverläufe mit entgegengesetzt ausgerichteten Spannungsamplituden induziert. Die Figuren. 2a und 2b zeigen Beispiele für solche Spannungsverläufe bei Rück- und Vorlauf (FIG. 2a bzw. 2b); hier für den Fall zweier Permanentmagnete und einer Spule mit weichmagnetischem Kern.

Fig. 2a ist eine Darstellung des zeitlichen Spannungsverlaufs $U(t)$ der Spannung zwischen einem ersten Spulenanschluss und einem zweiten Spulenanschluss bei einem durch eine Schussabgabe verursachten Verschlussrücklauf. Bevor der erste oder der zweite Magnet sich in den Bereich der Spule 114 bewegen, ist ein Spannungswert $U0$ messbar. Bei Eintritt des ersten Magneten 113 in den Bereich des mittleren Zinkens des Spulenkerns ändert sich dort das magnetische Feld, was einen ersten Spannungsausschlag $U1$ induziert. Beim nachfolgenden Eintritt des zweiten Magneten 111 in den Bereich des mittleren Zinkens des Spulenkerns wird das Magnetfeld um 180° umgepolt, was einen zweiten Spannungsausschlag $U2$ induziert. Auf Grund der Umpolung ist dessen Verlauf dem des ersten Spannungsausschlags $U1$ entgegengesetzt und dessen Amplitude, wegen der größeren relativen Änderung der Feldstärke wesentlich größer als die des ersten Spannungsausschlags $U1$. Im dargestellten Ausführungsbeispiel ist die Amplitude des zweiten Spannungsausschlags $U2$ wenigstens eineinhalbmal so groß wie die Amplitude des ersten Spannungsausschlags $U1$. Sobald die Magnete den Bereich des mittleren Zinkens des Spulenkerns wieder verlassen, schwächt sich das magnetische Feld im mittleren Zinken ab. Diese erneute Änderung des Feldes verursacht den dritten Spannungsausschlags $U3$. Da mit dem Abschwächen aber keine Umpolung verbunden ist, ist die Amplitude des dritten Spannungsausschlags $U3$ wesentlich kleiner als die Amplitude des zweiten Spannungsausschlags $U2$. Im gezeigten Ausführungsbeispiel ist die Amplitude des zweiten Spannungsausschlags $U2$ wenigstens eineinhalbmal so groß wie die Amplitude des dritten Spannungsausschlags $U3$. Nach dem dritten Spannungsausschlags $U3$ geht die Spannung auf den bleibenden Spannungswert $U0$ zurück.

Der Spannungsverlauf $U(t)$ zeigt außerdem kleinere Spannungsausschläge $U01$, $U30$. Der erste kleinere Spannungsausschlag $U01$ entsteht, wenn der erste Magnet 113 den vorderen Zinken ohne Spulenwicklungen passiert. Der zweite kleinere Spannungsausschlag $U30$ entsteht, wenn der zweite Magnet 111 den hinteren Zinken ohne Spulenwicklungen passiert.

Ganz analog, jedoch mit umgekehrten Vorzeichen ergibt sich der beim Vorlauf induzierte Spannungsverlauf.

Dieser ist mit seinen entsprechenden Spannungswerten U0, U4, U5, U6, U04 und U60 in FIG. 2b gezeigt.

Die Signale des Rück- und des Vorlaufs unterscheiden sich neben dem Vorzeichen auch quantitativ in den Größen der Amplituden und in ihren Dauern. Dies zeigt z.B. Fig. 2c. Das aus einem Verschlussrücklauf resultierende Signal ist innerhalb eines ersten Zeitbereichs t1 zu sehen und das aus einem Verschlussvorlauf resultierende Signal in einem zweiten, späteren Zeitbereich t2. Wie man sieht, ist t1 dabei kürzer als t2. Das liegt daran, dass der durch die Schussabgabe direkt verursachte Rücklauf des Schlittens mit höherer Geschwindigkeit erfolgt als der durch die Verschlussfeder verursachte Vorlauf. Der schnellere Rücklauf sorgt zudem für schnellere Änderungen des Magnetfelds und somit für höhere induzierte Spannungen. Daher ist der Spannungswert U2 auch höher als der Spannungswert U5.

Derart induzierte Signale können dann einer Signalauswerteinheit, z.B. bestehend aus einem Microcontroller, zur Analyse zugeführt werden. Zuvor können die Signale noch in einer oder mehreren Signalverarbeitungseinheiten, wie Filter-, Gleichrichter- oder Verstärkerschaltungen weiter- bzw. vorverarbeitet werden.

Werden mehr als zwei Magnete 111, 113 verwendet, kann das Signal zudem entsprechend verlängert werden. Ein längeres Signal, kann z.B. durch eine die Spannung kumulierende Schaltung verstärkt werden. Ein entsprechend lang andauerndes und starkes Signal kann dann auch zur Spannungsversorgung weitere Bauteile, z.B. von e-paper-Displays, verwendet werden.

Fertigungsbedingt kann es zwischen den beweglichen und stationären Waffenteilen zu bei einer Bewegung variierenden Abständen kommen. Die Abstände können sich auch von Waffe zu Waffe unterscheiden. Da sich die magnetische Feldstärke mit dem Quadrat der Entfernung ändert, schwanken die Signalstärken stark in Abhängigkeit von diesen Toleranzen. Dies kann eine zuverlässige Schussdetektion problematisch machen. Z.B. können erforderliche allgemeine Signalschwellwerte auf Grund von Signalschwankungen nur schwer zuverlässig festlegbar sein. Z.B. ist aufgrund der erwähnten Signalschwankungen eine allgemeine Toleranzfestlegung von Signalgrenzen zur Ermittlung eventueller Schussauslösungen oder manueller Durchladungen in der Praxis kaum umsetzbar. Zusätzlich zu den Schwankungen kann das Signal auf Grund von zu großen Abständen insgesamt zu schwach ausfallen. Letztlich müssen Signalschwankungen also entweder reduziert werden und/oder die erforderlichen Schwellwerte dynamisch, also unter Berücksichtigung von individuellen Signalschwankungen bestimmt werden. Zudem, oder ggf. auch unabhängig davon, muss sichergestellt werden, dass die gemessenen Signale für eine sinnvolle Messung ausreichend stark sind.

Theoretisch können permanente Schleifkontakte oder federbelastete sich kontaktierende Signalerzeugungselemente verwendet werden. Sie würden die Abstände zwischen Permanent- und Spulenkern und somit deren Toleranzen, welche eben im Quadrat ihrer Entfernungen in die Signalintensität eingehen, ausreichend konstant und auch geringhalten. In der Praxis würde dies jedoch einen beträchtlichen zusätzlichen konstruktiven Aufwand erfordern.

Eine fertigungstechnisch vorteilhafte Lösung zur Erhöhung der induzierten Spannungen, besteht darin, mehrere Reihen von Permanentmagneten parallel, also nebeneinander anzuordnen. Insbesondere kann es sich um 2N Permanentmagnete handeln. Die bereits zu FIG 1 erläuterte Spule mit dreizinkigem, weichmagnetischem Kern würde in diesem Fall um 90° gedreht werden. Treten also z.B. bei der in FIG. 1 gezeigten Anordnung der signalerzeugenden Magnete Schwierigkeiten durch gerätebedingte große oder unterschiedliche Abstände zwischen den signalerzeugenden Magneten und Spulen auf, können die Magnete in mehreren parallelen Reihen mit alternierenden Polaritäten auf dem beweglichen Teil der Schusszählervorrichtung angebracht werden.

FIGen 3a-d zeigen einige Beispiele für die Anordnung einer Spule mit dreizinkigem magnetisierbarem Kern und einer Reihe alternierend gepolter Permanentmagnete. Das Signal kann dabei durch ein Verlängern der Reihe durch weitere Weichmagnete verstärkt und verlängert werden. Wird die induzierte Spannung, wie z.B. in EP 3 140 605 B1 (Heckler & Koch GmbH) dargelegt, auch zum Betrieb der Signalauswerteeinheit, z.B. eines Microcontrollers, verwendet, hängt die Dauer der zur Verfügung stehenden Betriebsspannung von der Anzahl der hintereinander angeordneten Magnete ab. Je mehr Magnete hintereinander angeordnet werden, desto länger ist die Signaldauer und damit die Dauer der verfügbaren Betriebsspannung für die Signalverarbeitung.

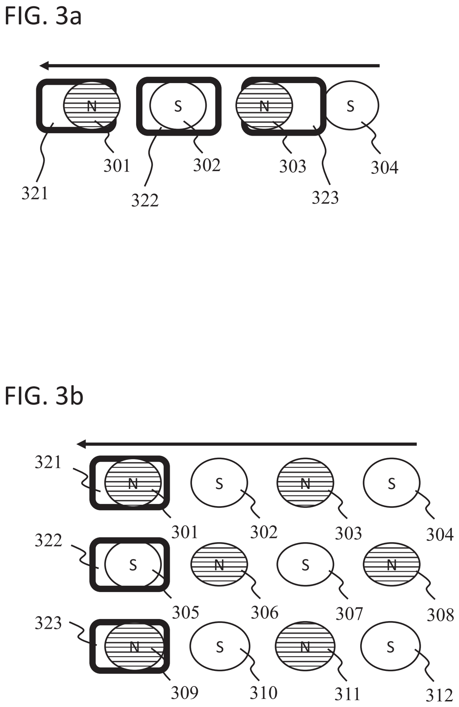

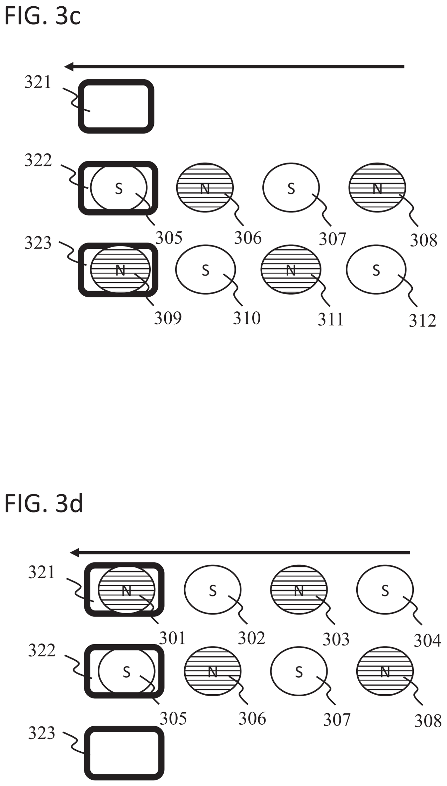

FIG. 3a zeigt schematisch vier in Reihe angeordnete, alternierend gepolte Permanentmagnete 301 - 304, die eine Spule mit dreizinkigem Kern überstreichen. Die Zinken 321 - 323 sind dabei in horizontaler Richtung angeordnet. Jedes Rechteck stellt dabei jeweils eine Zinke 321 - 323 in Draufsicht dar. Die Magnete überstreichen die Spule in Richtung des Pfeils. Durch die Anordnung der Magnete in einer Reihe wird das induzierte Signal verlängert, jedoch noch nicht verstärkt.

FIG. 3b zeigt schematisch eine Anordnung bei der die Reihen der Permanentmagnete in vertikaler Richtung, also parallel, angeordnet sind. Insgesamt gibt es hier zwölf Permanentmagnete 301 - 312, wobei die Polarität sowohl horizontaler als auch in vertikaler Richtung alterniert. Die Spule mit dreizinkigem Kern ist hier um 90° gedreht, so dass die Zinken 321 - 323 entlang der vertikalen Richtung angeordnet sind. Die Zinken des Kerns werden dabei gleichzeitig von jeweils drei Magneten überstrichen. Dies erhöht die Feldstärken der im Kern erzeugten Magnetfelder. Damit einhergehend erhöhen sich auch die in der Spule induzierten Spannungen und damit die Signalstärken. Auf diese Weise können also auch größere Abstände zwischen Permanentmagneten und Spule vorliegen, ohne dass dabei das Signal zu schwach ausfällt.

FIGen 3c und 3d zeigen schematisch Variationen der in FIG 3b gezeigten Anordnung mit nur zwei Reihen bzw.

acht Permanentmagneten.

Die konkrete Anordnung der Permanentmagnete kann z.B. auch zum Identifizieren der Waffenteile, in oder an denen sie angeordnet sind, dienen. So können z.B. verschiedene Verschlusssysteme durch eine entsprechende Auswahl an Permanentmagneten und Längen von Permanentmagnetanordnungen kodiert und damit identifiziert werden. Z.B. werden beim realitätsnahen Üben mit Farbmarkiermunition FX- oder UTM-Übungsverschlusssysteme verwendet, deren Verschlüsse sich von den Standardverschlüssen für den scharfen Schuss unterscheiden. Diese könne z.B. längere oder kürzere Anordnungen von Permanentmagneten besitzen. Z.B. kann der Standardverschluss vier Permanentmagnete umfassen, während der Übverschluss fünf oder sechs umfasst. Eine weitere Möglichkeit zur Unterscheidung ist Magnete verschiedener Größe und Stärke zu verwenden und verschiedene Verschlüsse darüber zu kodieren. Beide Ansätze können auch kombiniert werden. So kann zum Beispiel eine ungeradzahlige Anzahl 2N+1 von Magneten verwendet werden und der zusätzliche (2N+1)-ste Magnet z.B. deutlich kleiner oder schwächer gewählt werden, oder dessen Abstand zum Magneten davor nicht dem Abstand der übrigen Magnete zueinander entsprechen. Das Signal dieses Magneten ist im Gesamtsignal erkennbar, so dass trotz ungeradzahliger Anzahl von Magneten die Unterscheidung Vor- zu Rücklauf möglich bleibt. In einem zur Signalauswertung verwendeten Microcontroller können diese Verschluss-Kodierungen dann zur Erkennung und Auswertung entsprechend gespeichert werden.

Zusätzlich zum Messsignal kann ein Referenzsignal erzeugt werden, das z.B. als dynamischer, also vom Zeitverlauf und den individuellen Geometrien abhängiger, Schwellwert herangezogen werden kann. Dieser und weitere Aspekte der Erfindung sollen im Folgenden erläutert werden.

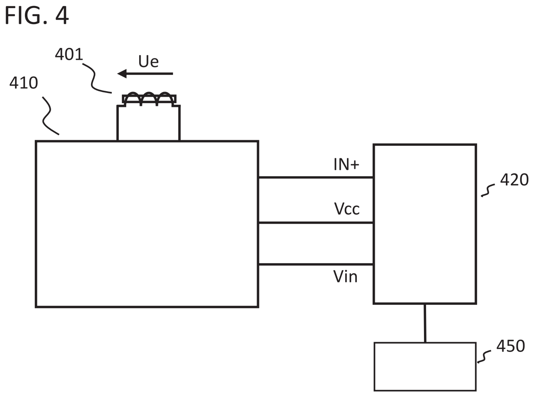

FIG. 4 zeigt einen Blockschaltbild einer Beispielschaltung zum Erzeugen einer Messspannung $IN_+$ und optional einer zusätzlichen Referenzspannung $V_{in}$, die einer Signalauswerteeinheit 420 zugeführt werden. Dabei wird eine Wechselspannung $U_e$ durch eine Spannungserzeugungseinheit 401, in diesem Beispiel induktiv durch eine Spule, erzeugt. In einer Signalverarbeitungseinheit 410 werden daraus Mess- und Referenzsignale erzeugt. Die Signalverarbeitungseinheit 410 kann z.B. nur aus einem ADC und einer Gleichrichterschaltung zum Gleichrichten von Spannungen bestehen und/oder weitere Elemente umfassen. Mittels eines Gleichrichters kann z.B. das Messsignal $IN_+$ halbwellengleichgerichtet und das Referenzsignal $V_{in}$ gleichgerichtet werden. Mittels des ADC können dann aus der IN+ und Vin für die Signalauswerteeinheit 420 verarbeitbare Signale erzeugt werden und diese in der Signalauswerteeinheit 420 ausgewertet werden.

Zusätzlich kann, wie in FIG. 4 gezeigt, eine oder mehrere Zeitbestimmungseinheiten 450 vorgesehen sein. Mit diesen können die zwischen verschiedenen Zeitpunkten verstrichenen Zeiten gemessen werden.

In einer Ausführungsform umfasst eine der Zeitbestimmungseinheiten z. B. eine interne oder externe Taktquelle in Kombination mit einem Timer. Der Timer zählt dabei die Takte und kennt die Zeitabstände zwischen den einzelnen Takten. Daraus kann er dann eine Zeit berechnen. Eine der Zeitbestimmungseinheiten kann zudem auch einen sich über eine Last definiert entladenden Kondensator umfassen. Hierbei lädt sich der Kondensator bei jedem Schusssignal über die während eines Rück- und/oder Vorlaufs erzeugte und dann gleichgerichtete Wechselspannung $U_e$ elektrisch auf und entlädt sich definiert über die Last, z.B. einen Widerstand. Der Kondensator entlädt sich dabei auch dann kontinuierlich über die Last, wenn die Signalauswerteeinheit 420 keine Betriebsspannung mehr zur Verfügung hat. Sobald die Signalauswerteeinheit 420 nach einem Schuss wieder mit einer Versorgungsspannung versorgt wird, misst diese mittels Analog-Digital Konverter die Spannung am Kondensator und wertet diese aus. Die Zeitabstände/Dauern werden dabei über den Grad der Entladung des Kondensators bzw. die Spannung am Kondensator abgeschätzt.

Zusätzlich kann aus der Ausgangspannung $U_e$ eine Versorgungsspannung $V_{cc}$ zum Betreiben der Signalauswerteeinheit 420 und der Zeitberechnungseinheit 450 erzeugt werden.

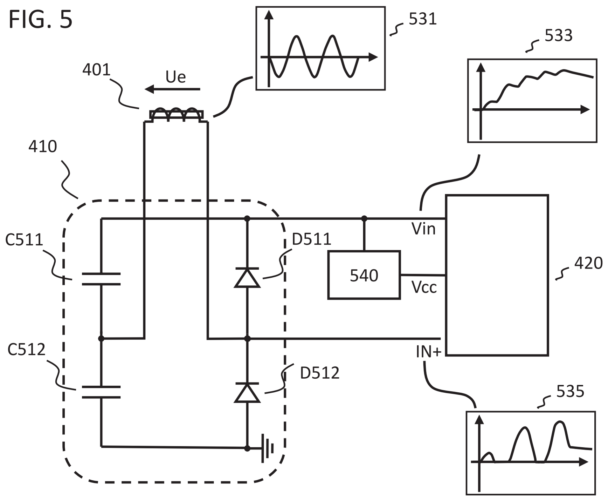

FIG. 5 zeigt ein Ausführungsbeispiel, bei dem die Signalverarbeitungseinheit 410 zum Gleichrichten eine Spannungsvervielfacherschaltung, insbesondere eine Signalverdopplungsschaltung, besonders eine Delon-Schaltung, aufweist.

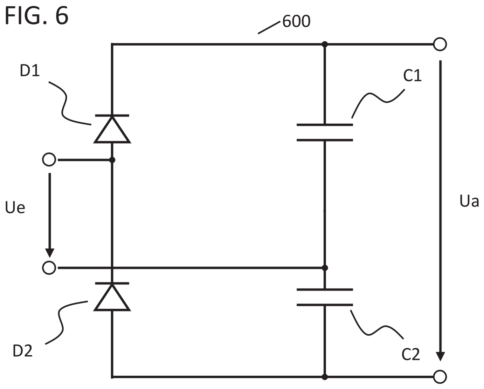

FIG. 6 zeigt eine solche Delon-Schaltung 600. Die Delon-Schaltung besteht aus jeweils zwei Dioden D1 und D2 (Einweg-Gleichrichterschaltungen), sowie zwei Kondensatoren C1 und C2, denen eine Last (nicht dargestellt) nachgeschaltet ist. Wenn nun ein zeitlich begrenztes Wechselspannungssignal (z.B. ein bei einer Schussabgabe induziertes) $U_e$ in die Delon-Schaltung eingekoppelt wird, geschieht Folgendes:

Aus der positiven Halbwelle des Wechselspannungssignals $U_e$ erzeugt die Diode D1 eine pulsierende Gleichspannung. Die Diode D2 erzeugt aus der negativen Halbwelle des Wechselspannungssignals eine pulsierende Gleichspannung. Die Sperrspannung der beiden Dioden D1 und D2 muss dabei mindestens doppelt so groß sein wie der Scheitelwert des eingekoppelten Wechselspannungssignals. Die beiden Kondensatoren C1 und C2 werden dadurch abwechselnd, fast auf den Scheitelwert des Wechselspannungssignals $U_e$ aufgeladen. Die gleichgerichtete Spannung $U_a$ am Ausgang der Delon-Schaltung ist dann im unbelasteten Fall ungefähr doppelt so groß wie der Scheitelwert des eingekoppelten Wechselspannungssignals.

Zurückkommend zu FIG. 5 wird, wenn die Spule 401 von den alternierend gepolten Permanentmagneten überstrichen wird, in der Spule eine Wechselspannung $U_e$ induziert. Im Folgenden wird das direkt an der Spule 401 als Wechselspannung $U_e$ messbare Signal als Basissignal/Ausgangssignal $IN_0$ bezeichnet. Der qualitative Verlauf von $IN_0$ ist

in Plot 531 gezeigt. Aus $IN_0$ werden in der Signalverarbeitungseinheit 410 dann das Messsignal $IN_+$ und das Referenzsignal $V_{in}$ erzeugt. Die qualitativen Verläufe von $IN_+$ und $V_{in}$ sind in Plots 533 und 535 gezeigt. Zudem wird in diesem Beispiel mit Hilfe eines Linearreglers 540 eine Betriebsspannung $V_{cc}$ zum Betreiben der Signalauswerteeinheit 420 erzeugt.

Zur Erzeugung des Referenzsignals $V_{in}$ wird die Spannung über beide Dioden D511 und D512 abgegriffen. Sie entspricht damit der Summe der jeweils an den Kondensatoren C511 und C512 anliegenden Spannungen und würde sich theoretisch mit jeder Halbwelle solange erhöhen bis beide Kondensatoren vollständig geladen sind. Das Basissignal $IN_0$ wird also in üblicher Weise an der Delon-Schaltung gleichgerichtet und aufaddiert. Die Spannung würde dabei theoretisch letztlich verdoppelt werden. In der Praxis kommt es jedoch beim Durchlaufen jeder der Dioden D511 und D512 zu einem, von der Diode abhängigen Spannungsverlust $\Delta U$, z.B. 0,3 V. Daher wird die Spannung des nach Durchlauf der Delon-Schaltung vorliegenden Signals um $2 \times \Delta U$ verringert, also z.B. um 0,6 V. Das Referenzsignal $V_{in}$ kann weiterhin mittels eines der Delon-Schaltung folgenden Spannungsteilers auf eine niedrigere Spannung gesenkt werden.

Zur Erzeugung des Messsignals $IN_+$ wird in diesem Ausführungsbeispiel das Basissignal $IN_0$ in der Signalverarbeitungseinheit 410 halbwellengleichgerichtet, wobei weitere Signalverarbeitungsschritte davor oder danach möglich sind. Das bedeutet, dass aus dem Wechselspannungssignal $IN_0$ ein pulsierendes Signal $IN_+$ erzeugt wird, in das nur die Halbwellen mit negativen oder positiven Spannungsamplituden eingehen. Beispielsweise wird dazu, wie in FIG. 5 dargestellt, für das Messignal $IN_+$ nur die an der Diode D512 anliegende Spannung abgegriffen. Somit liegt dort nur bei negativen Halbwellen eine Spannung an, während bei positiven Halbwellen auf Grund der auf Durchlass geschalteten Diode D512 keine Spannung anliegt. Dadurch wird ein halbwellengleichgerichtetes und durch die Kondensatoren C511 und C512 aufaddiertes Messsignal $IN_+$ erzeugt. Da $IN_+$ nur an einer Diode, nämlich D512, abgegriffen wird, ist dessen Spannung während der negativen Halbwellen um $\Delta U$ größer als die des Referenzsignals $V_{in}$, das über beide Dioden abgegriffen wird. In manchen Ausführungsbeispielen kann das Messsignal $IN_+$ noch mittels eines hier nicht dargestellten Spannungsteilers auf eine niedrigere Spannung gebracht werden. Auch hier gilt, dass das Verhältnis der Widerstände des Spannungsteilers so gewählt werden muss, dass der Scheitelwert von $IN_+$ nicht größer wird als die Versorgungsspannung $V_{cc}$, um sicherzustellen, dass das Signal $IN_+$ innerhalb des vom ADC erkennbaren Spannungsbereichs liegt.

Die über den beiden Dioden D511 und D512, bzw. über den beiden Kondensatoren C511 und C512, abgegriffene Spannung wird in diesem Ausführungsbeispiel zudem mittels des Linearreglers 540 auf eine Betriebsspannung $V_{cc}$, z.B. 3,3 V, geregelt. $V_{cc}$ dient dann zum Betreiben der Signalauswerteeinheit, die insbesondere einen Mikrocontroller umfassen kann. Sobald $V_{cc}$ größer ist als der zum Betrieb der Signalauswerteeinheit notwendige Spannungswert, z.B. 1,8V, wird die Signalauswerteeinheit aktiv und misst die Spannungen $IN_+$ und $V_{in}$. Diese Messung kann z.B. über einen internen Analog-Digital Konverter (ADC) der Signalauswerteeinheit erfolgen.

Dabei gibt es ein Spannungsintervall von $V_{cc}$ innerhalb dessen die Detektion der Verschlussbewegung erfolgt. Die nach diesem Intervall und nach Abschluss der Detektion weiterlaufende Stromerzeugung wird dazu verwendet, die Signalauswerteeinheit und die ihr zugeordneten Geräte bis zum Abschluss aller vorgegebenen Schussanalysefunktionen zu betreiben.

Die Länge dieses Intervalls wird bestimmt durch den Zeitpunkt, in welchem die Signalauswerteeinheit 420 genügend Energie erhält, um mit der Signalabtastung und - auswertung zu beginnen und dem Zeitpunkt, an welchem das Messignal definitiv unter das Referenzsignal fällt. Dieser Zeitpunkt ist erreicht, wenn die zeitlichen Abstände zwischen den Amplitudentiefstständen und Amplitudenhöchstständen, d.h. die Flankenbreiten zwischen diesen Amplitudenstellungen um einen gewissen Zeitraum überschritten werden (z.B. die doppelte Dauer der zwei größten Flankenbreiten überschritten wird).

Durchläuft, wie oben beschrieben, $V_{in}$ einen Spannungsteiler, muss das Verhältnis der Widerstände des Spannungsteilers so gewählt werden, dass der Scheitelwert von $V_{in}$ nicht größer wird als die Versorgungsspannung $V_{cc}$. So ist z.B. gewährleistet, dass für die Abtastung das Signal $V_{in}$ innerhalb eines, z.B. von einem ADC der Signalauswerteeinheit 420, erkennbaren Spannungsbereichs liegt.

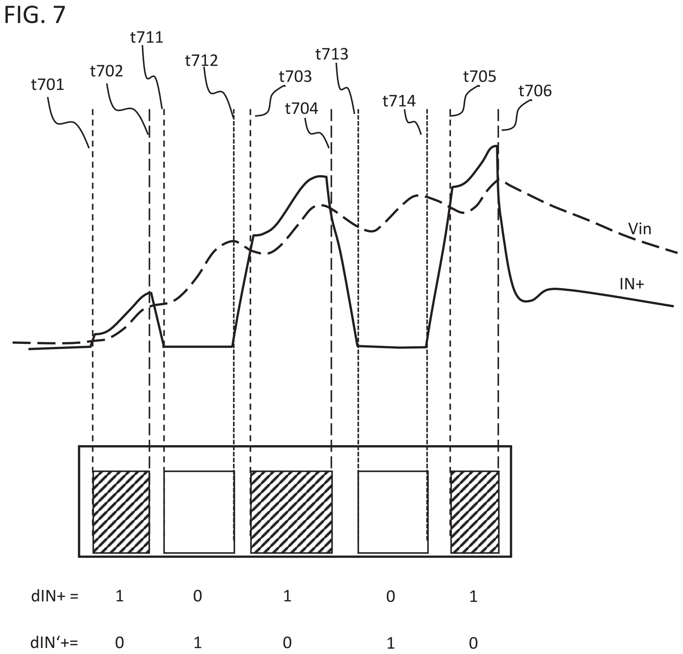

FIG. 7 stellt nun grafisch dar, wie aus einem Vergleich des Messsignals und des Referenzsignals $V_{in}$ Zeitpunkte bestimmt werden, die z.B. für einen Vor- oder Rücklauf des Verschlusses einer Waffe indikativ sind. Grundsätzlich muss für das beschriebene Vorgehen das Messignal nur oszillieren und nicht zwingend, wie in FIG.7 gezeigt, halbwellengleichgerichtet sein. Das Messsignal kann also grundsätzlich auch Halbwellen mit negativen und positiven Halbwellen umfassen.

Die in FIG. 7 gezeigten Zeitpunkte t701 - t706 und t711- t714 werden wie folgt bestimmt:
Zu den Zeitpunkten t701, t703 und t705 überschreitet das Messsignal $IN_+$ das Referenzsignal $V_{in}$. In den in FIG. 7 gezeigten Signalverläufen entspricht das den Punkten, an denen das zunächst kleinere Messignal das zunächst größere Referenzsignal kreuzt. Zu den Zeitpunkten t702, t704 und t706 unterschreitet das Messsignal das Referenzsignal oder eine von diesem abgeleitete Schwellenwertspannung $U_0$. In den in FIG. 7 gezeigten Signalverläufen entspricht das den Punkten, an denen das zunächst größere Messignal das zunächst kleinere Referenzsignal kreuzt. Ferner können Zeitpunkte t711 - t714 bestimmt werden, zwischen denen das Messignal kleiner oder gleich einem weiteren vorbestimmten Schwellenwert ist. In den in FIG. 7 gezeigten Signalverläufen ist der Schwellenwert Null und die Zeitpunkte t711 und t713 entsprechen den Punkten, an denen das zunächst größere Messignal Null wird, und die Zeitpunkte t712 und t714 entsprechen den Punkten, an denen das Messignal größer als Null wird.

Die Schwellenwertspannung $U_0$ dient dabei als vorbestimmbarer Schwellenwert und ist in jedem Fall kleiner oder gleich dem Minimalwert des Referenzsignals.

Die zeitlichen Abstände zwischen zwei Zeitpunkten bzw. die verstrichenen Zeitdauern (Zeitabschnittsdauern) der durch den ersten und den zweiten Zeitpunkt definierten Zeitabschnitte können mittels einer der oben beschriebenen Zeitbestimmungseinheiten 450 bestimmt werden.

So kann beispielsweise die Durchlaufdauer, d.h. die zeitliche Durchlauflänge der ermittelten Signale, bestimmt werden. So kann etwa als erster Zeitpunkt t701, derjenige Moment gewählt werden, an dem das Messignal, d.h. die erste Amplitude dieses Signals, erstmals größer als das Referenzsignal ist, und als zweiter Zeitpunkt t706, derjenige Moment gewählt werden, an dem es definitiv niedriger ist und bleibt als das Referenzsignal. Die zeitliche Differenz dieser beiden Momente ergibt dann die oben genannte Durchlaufdauer. Alternativ kann der zweite Zeitpunkt t706 z.B. auch so wie im Falle des oben beschriebenen Spannungsintervalls von $V_{cc}$, innerhalb dessen die Detektion der Verschlussbewegung erfolgt, bestimmt werden und/oder der erste Zeitpunkt t701 z.B. auch durch den Zeitpunkt definiert werden, an dem die Betriebsspannung größer als der zum Betrieb der Signalauswerteeinheit notwendige Spannungswert wird. Ist die Länge der Strecke, entlang der die dem Messignal zu Grunde liegende Wechselspannung $U_e$ erzeugt wird bekannt, kann daraus zusammen mit der Durchlaufdauer die mittlere Geschwindigkeit eines Rücklaufs oder Vorlaufs bestimmt werden.

In einem weiteren Beispiel können zur Geschwindigkeitsbestimmung alternativ oder zusätzlich auch die Zeitabstände zwischen zwei aufeinander folgenden, positiven Flanken bestimmt werden. In der FIG. 7 entspricht dies z.B. den Zeitpunkten t701 (erster Zeitpunkt) und t703 (zweiter Zeitpunkt) oder t703 (erster Zeitpunkt) und t705 (zweiter Zeitpunkt). Der Zeitabstand zwischen diesen ersten und zweiten Zeitpunkten entspricht dann in etwa einer Periode der Wechselspannung $U_e$. Im Falle der z.B. in FIGen. 3a-d beschriebenen Magnet-Spulen-Anordnungen zur Spannungserzeugung entspricht eine Periode genau einem Überstreichen der Spule durch zwei aufeinanderfolgende Permanentmagneten. Sind wiederum die Abstände d und Breiten x der Magnete bekannt, kann die Geschwindigkeit während dieses Zeitintervalls bestimmt werden, z.B. über:

$$v = \frac{2x + 2d}{t705 - t703} \, .$$

Bevorzugt wird die Geschwindigkeit über den Abstand zwischen zwei Magneten und das Zeitintervall abgeschätzt:

$$v = \frac{d}{t705 - t703} \, .$$

Analog können dazu auch die Zeitabstände zwischen negativen Flanken über die Zeitpunkte t702, t704 und t706 oder die Zeitabstände zwischen Zeitpunkten t711 und t713 bzw. t712 und t714 verwendet werden.

Aus mehreren derart bestimmten und zu aufeinanderfolgen Zeitabschnitten/Zeitintervallen gehörigen Geschwindigkeiten kann eine mittlere Bewegungsgeschwindigkeit oder sogar die Beschleunigung der jeweiligen Verschlussbewegung abgeschätzt werden. Die Beschleunigung wird dabei über wenigstens zwei Geschwindigkeiten und die zeitlichen Abstände zwischen den zugehörigen Zeitabschnitten bestimmt; z.B. im Falle zweier Geschwindigkeiten gemäß

$$a = \frac{dv}{dt} \approx \frac{v(t_2) - v(t_1)}{t_2 - t_1} \, .$$

Ganz allgemein gilt: sind der Abstand und die Länge des spannungserzeugenden Teils der Spannungserzeugungseinheit 110 bekannt, lässt sich aus der Dauer des Signals bzw. den Dauern einzelner Signalabschnitte die Geschwindigkeit und ggf. auch die Beschleunigung ermitteln, mit welcher sich der spannungserzeugende Teil der Waffe beim Schuss oder beim manuellen Durchladen im Rück- und Vorlauf bewegt. Hierdurch lassen sich z.B. die schnellen Bewegungen der Verschlüsse bei Schussabgabe von den langsameren Bewegungen beim manuellen Durchladen unterscheiden. Über die Beschleunigung kann darüber hinaus auch auf die verwendete Treibladung zurückgeschlossen werden.

In einer Ausführungsform ist zusätzlich oder alternativ zu der oben beschriebenen Messung der Beschleunigung der Verschlussbewegung in der Schusswaffenanalysevorrichtung ein batterieunabhängiger oder auch batterieabhängiger Beschleunigungssensor vorgesehen.

Ein bei batterielosen Schusszählern auftretendes Problem hinsichtlich der Messung von dynamischen Beschleunigungen an der Waffe mittels Sensors war bisher, dass diese Beschleunigungen nicht gemessen und registriert werden konnten, da die Signalauswerteeinheit zum Zeitpunkt der Signalentstehung ggf. noch stromlos war.

In einer Ausführungsform wird dieses Problem gelöst, indem das Beschleunigungssignal, in einem Ladekondensator solange zwischengespeichert wird, bis die Signalauswerteeinheit ausreichend mit Strom für die Auswertung des gespeicherten Beschleunigungssignals versorgt wird.

Anhand der gemessenen Beschleunigung kann das Verschießen von unterschiedlichen Munitionssorten (Gefechtsmunitionssorten, Manövermunition, Übungsmunition) detektiert und ggf. gespeichert werden. Das kann z.B. anhand der unterschiedlichen Beschleunigungsimpulse beweglicher Teile wie dem Verschluss oder der unterschiedlichen Rückstoßimpulse am Gesamtsystem erfolgen.

In einer weiteren Ausführungsform wird das Messsignal in ein digitales Messignal $dIN_+$ umgewandelt. Dies kann z.B. nach der Regel

$$\text{if } (IN_+ \geq V_{in})$$

$$dIN_+ = 1$$

$$\text{elseif } (IN_+ \leq U_t)$$

$$dIN_+ = 0$$

$$\text{else}$$

$$dIN_+ = \text{leer},$$

wobei $U_t \leq \min(V_{in})$, geschehen.

In einer weiteren Ausführungsform wird eine digitales Messsignal $dIN'_+$ nach der Regel

$$\text{if } (IN_+ \geq V_{in})$$

$$dIN'_+ = 0$$

$$\text{elseif } (IN_+ \leq U_t)$$

$$dIN'_+ = 1$$

$$\text{else}$$

$$dIN'_+ = \text{leer}$$

erzeugt.

FIG. 7 illustriert beide beispielhaften Prinzipien. Ist das Messsignal größer oder gleich dem Referenzsignal, so hat das digitale Messignal in diesem Zeitintervall den Wert 1 (bzw. 0). Ist das Messsignal kleiner als eine Schwellenwertspannung $U_0$, hat das digitale Messignal in diesem Zeitintervall den Wert 0 (bzw. 1). Die Schwellenwertspannung $U_0$ dient dabei als vorbestimmbarer Schwellenwert und ist in jedem Fall kleiner oder gleich dem Minimalwert des Referenzsignals. In allen anderen Fällen wird dem digitalen Messignal kein Wert zugewiesen. In FIG. 7 ist dies durch schraffierte und nicht-schraffierte Blöcke dargestellt. Die Dauern der Signalintervalle (Breite der Blöcke), während denen das digitale Messignal 1 oder 0 ist, und ggf. auch während denen ihm kein Wert zugewiesen ist (leer), können z.B. wieder über die Zeitpunkte t701-t706 bzw. t711 - t714 bestimmt werden. Z.B. können die Zeitpunkte t701, t703 und t705 über die Zeitpunkte bestimmt werden, zu denen das digitale Messignal $dIN_+$ von "0" oder "leer" auf "1" wechselt, und die Zeitpunkte t702, t704 und t706 über die Zeitpunkte, zu denen das digitale Messignal ($dIN+$) von "1" oder "leer" auf "0" wechselt.

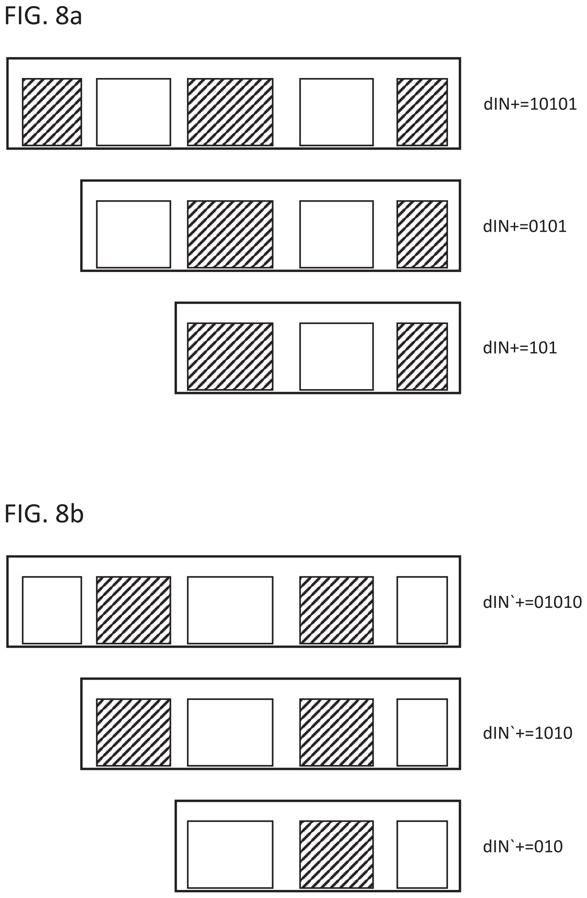

In einem Ausführungsbeispiel kann aus der Reihenfolge der Digits, also der Nullen und Einsen, des jeweils gemessenen Signals ermittelt werden, ob ein Vor- oder Rücklauf des Verschlusses vorliegt. Denn sind die der Spule zugewandten Pole der jeweiligen Magnete und das Vorzeichen der Spannung, die sie beim Überstreichen der Spule induzieren, bekannt, so identifiziert die gemessene 1-0-Folge eindeutig, ob ein Vor- oder Rücklauf vorliegt. Führt der Rücklauf, wie in FIG. 8a gezeigt, zu der Folge 10101, führt der Vorlauf zwingend zu der in FIG. 8b gezeigten, dazu inversen Folge 01010. Vorteilhafterweise kann eine solche Identifizierung der Bewegungsrichtung des Verschlusses auch dann bestimmt werden, wenn die Signalauswerteinheit das Signal nicht vollständig erfassen konnte, z.B. weil die für die Signalauswertung erforderliche Betriebsspannung erst später erreicht wurde. Dies illustrieren FIG.8a und 8b, in denen zu sehen ist, dass die für eine Bewegungsrichtung typische Abfolge der Digits bis zu einer minimalen Anzahl von drei Digits für die Bestimmung der Bewegungsrichtung geeignet ist. Es kann also mit nur drei Digits des digitalen Messsignals eindeutig bestimmt werden, ob ein Vor- oder Rücklauf erfolgte. Je nachdem wann das Signal erfasst wurde, führt ein Rücklauf zu den Folgen 10101, 0101 und 101 und ein Vorlauf zu den Folgen 01010, 1010 und 010. Verzögert sich zum Beispiel die Spannungserzeugung für die Signalauswerteinheit oder fährt diese aus welchen Gründen auch immer zu langsam hoch, so reicht auch nach Nichtregistrierung des Signalanfangs zur Bestimmung der Bewegungsrichtung ein bestimmter charakteristischer Minimalabschnitt des Signals aus, die Bewegungsrichtung zu bestimmen. Mit der Bestimmung dieser mindestens drei Enddigits als richtungsspezifisches Signal vermeidet man Fehl- oder Nichtmeldungen von Signaldetektionen.

In weiteren Ausführungsformen bestimmt die Signalauswerteinheit, ob eine Schussabgabe im Einzel- oder Dauerfeuer erfolgt ist. Zudem ist es auch möglich die verschiedenen Kadenzen/Schussraten im Einzelfeuer zu bestimmen. Dazu können z.B. vorbestimmte zeitliche Grenzwerte, die z.B. auf im Labor bestimmten Messwerten basieren, Zeitintervalle/Zeitgrenzwertintervalle definieren. Das Intervall, innerhalb dem die ermittelte Dauer liegt, bestimmt dann, ob Dauerfeuer oder Einzelfeuer vorliegt, und/oder auch die Schussrate. Die folgenden Beispiele verdeutlichen diese Vorgehensweise.

Beispiel 1: ein zeitlicher Grenzwert, automatische Waffe. Liegt die Dauer über dem Grenzwert (Zeitintervall 1), wird Einzelfeuer angenommen; liegt sie unter dem Grenzwert (Zeitintervall 2), Dauerfeuer.

Beispiel 2: ein zeitlicher Grenzwert, halbautomatische Waffe. Liegt die Dauer über dem Grenzwert (Zeitintervall 1), wird langsames Einzelfeuer angenommen; liegt sie unter dem Grenzwert (Zeitintervall 1), schnelles Einzelfeuer.

Beispiel 3: zwei Grenzwerte, automatische Waffe. Liegt die Dauer über dem zweiten, größeren Grenzwert (Zeitintervall 1), wird langsames Einzelfeuer angenommen. Liegt sie zwischen dem ersten und dem zweiten Grenzwert (Zeitintervall 2), wird schnelles Einzelfeuer angenommen. Liegt sie unter dem Grenzwert (Zeitintervall 3), wird Dauerfeuer angenommen.

Anstelle eines zeitlichen Grenzwerts und Zeitdauern können je nach Ausführungsform bzw. verwendeter Zeitbestimmungseinheit auch ein Spannungsgrenzwert und gemessene Spannungswerte herangezogen werden.

Zur Bestimmung der Dauer kann beispielsweise dazu das Ende des Messsignals, das beim Vorlauf eines ersten Schusses erzeugt wird als erster Zeitpunkt und der Anfang des Messsignals, das beim Rücklauf eines zweiten, folgenden Schusses als zweiter Zeitpunkt bestimmt werden. Aus der Zeitdauer zwischen erstem und zweitem Zeitpunkt kann auf den zeitlichen Abstand zwischen einzelnen Schussabgaben geschlossen werden und daraus auf den Feuermodus und ggf. auch auf die Schussrate.

In einem Ausführungsbeispiel bestimmt die oben beschriebene, Taktquelle und Timer umfassende Zeitbestimmungseinheit die Dauer zwischen erstem und zweitem Zeitpunkt.

In einem weiteren Ausführungsbeispiel ist zur Feststellung von Einzelfeuer- oder Dauerfeuerschussfolgen die oben bereits beschriebene, einen Kondensator und einen Widerstand umfassende Zeitbestimmungseinheit nach dem Gleichrichten des Signals integriert. Wie beschrieben lädt sich der Kondensator bei einer Schussabgabe auf und entlädt sich danach kontinuierlich über den Widerstand. Je nach Ladezustand des Kondensators bei der Reaktivierung der Signalauswerteinheit bei der darauffolgenden Schussabgabe lässt sich die Abgabe von Einzelfeuer (lange Sequenzen oder Pausen führen zu geringerem Ladezustand) oder Dauerfeuer (sehr kurze Sequenzen führen zu höherem Ladezustand) bestimmen. Theoretisch kann der Grad der Entladung in einen Zeitwert umgerechnet werden. Der Umweg über eine Zeitwertbestimmung muss jedoch nicht genommen werden und es können die am Kondensator anliegenden Spannungswerte direkt verwendet werden. Sie repräsentieren dann einen entsprechenden Zeitwert ohne, dass dieser explizit berechnet werden muss. Zum Beispiel: unterschreitet der Spannungswert im Kondensator einen vorgegebenen Schwellwert, kann dies bei bekannter Entladedauer des Kondensators mit Widerstand als Schussfolge im Einzelfeuer ausgewertet werden. Fällt der Spannungswert im Kondensator nicht unter den Schwellwert, wird dies als Schussfolge im Dauerfeuer ausgewertet.

Ein weiteres Ausführungsbeispiel unterscheidet Einzel- oder Dauerfeuerschussfolgen durch folgende Vorrichtungen und Verfahren:

Überstreichen die alternativ gepolten Magnete die stationäre Spule, versorgt die induzierte Spannung die Signalauswerteinheit, z.B. bestehend aus einem Microcontroller, und die vorgeschalteten Kondensatoren mit Energie. Bei ausreichender Betriebsspannung ist die Signalauswerteinheit funktionsbereit und befindet sich in einem aktiven Modus. In diesem Modus wertet sie das Wechselspannungssignal wie beschrieben aus, aktiviert eine interne oder externe Taktquelle, sowie einen Timer und konfiguriert einen interruptfähigen Pin, z.B. eines Microcontrollers.

Danach wird die Signalauswerteeinheit in einen Low-Power Modus versetzt, in dem sie nur einen Bruchteil des Stromes benötigt und damit relativ lange während des Verschlusszyklus aktiv bleiben kann. Im Low-Power Modus wird die Signalauswerteeinheit ausschließlich von vorgeladenen Stützkondensatoren mit elektrischer Energie versorgt.

Nach einem Rücklauf bleibt sie daher solange aktiv, bis beim darauffolgenden Vorlauf erneut Spannung zum Betreiben der Signalauswerteeinheit induziert wird. Die erneute Spannungsinduktion wird der Signalauswerteeinheit über eine zusätzliche Synchronisationsschaltung kommuniziert. Die Synchronisationsschaltung kann z.B. am interruptfähigen Pin eine Spannung anlegen, woraufhin dieser ein Interrupt in der Signalauswerteeinheit generiert und die Signalauswerteeinheit wieder vom Low-Power in den aktiven Modus wechselt.

Während sich die Signalauswerteeinheit im Low-Power Modus befindet, zählt der Timer die Takte der Taktquelle. Da die Taktfrequenz der Taktquelle bekannt ist, kann die Signalauswerteeinheit die vom Timer abgerufene Anzahl der Takte in einen Zeitwert umrechnen. Das geschieht, sobald sie wieder von einem Schusssignal mit einer Betriebsspannung versorgt wird und in den aktiven Modus gewechselt ist so dass sie die gezählten Takte des Timers verwerten kann. Auf diese Weise ermittelt die Signalauswerteeinheit die Zeit zwischen zwei aktiven Phasen und kann damit die unterschiedlichen Schussfolgen bestimmen.

Bei der Verwendung eines Low-Power Modus können grundsätzlich zwei Szenarien auftreten:
Bei genügend kurzer Zeit zwischen zwei Schussabgaben reicht die Spannung in den Stützkondensatoren aus, die Signalauswerteeinheit bis zum nächsten Schusssignal im Low-Power Modus zu halten. Eine Synchronisations-Schaltung erzeugt dann eine Spannung an einem interruptfähigen Pin. Sobald im Low-Power Modus die Spannung am interruptfähigen Pin erzeugt ist, wird ein Interrupt generiert, welches der Signalauswerteeinheit das Vorhandensein eines neuen Schusssignals mitteilt. Danach wechselt die Signalauswerteeinheit wieder in den aktiven Modus und fängt an, wie oben beschrieben, das Wechselspannungssignal zu messen und auszuwerten.

Ein Vorteil dieser Low-Power Schaltung ist also, dass die Signalauswerteeinheit beim Verschlussrück- und Vorlauf permanent aktiviert bleibt und diese Aktivierung nicht unterbrochen wird und neu gestartet werden muss.

Im zweiten Fall liegt die Zeit zwischen zwei Schusssignalen so weit auseinander, dass die Ladung der Stützkondensatoren nicht ausreicht, die Signalauswerteeinheit permanent zu versorgen. In diesem Fall würde die Betriebsspannung unterhalb der für den ordentlichen Betrieb erforderlichen Mindestspannung liegen und die Signalauswerteeinheit wird deaktiviert. Beim nächsten Schusssignal wird die Signalauswerteeinheit mit einem Hardware-Reset gestartet.

Der Unterschied, ob der Wechsel in den aktiven Modus aus einem Low-Power Modus oder aus dem Aus-Zustand erfolgt, wird mittels eines internen Registers der Signalauswerteeinheit erkannt.

Eine weitere Ausführungsform nutzt diese beiden Szenarien zur Unterscheidung von Dauer- und Einzelfeuer. Bei den extrem kurzen Schusszyklen eines Dauerfeuers kann, im Gegensatz zum Einzelfeuer, die Signalauswerteeinheit im Low-Power Modus auch beim Verschlussvorlauf und bis zur Abgabe des nächsten Schusses aktiv bleiben und ist durchgehend bereit. Diese permanente Aktivierung über mehrere Schusszyklen hinweg dient dann als Unterscheidungsmerkmal zwischen Dauerfeuer und Einzelfeuer, da beim letzteren die Aktivierung in der Regel unterbrochen sein wird. Zudem können so auch die Zeiten, die über einen Schusszyklus hinaus gehen, gemessen werden. Das Resultat bei dieser Lösung, ist direkt eine Zeit (Takte). Zudem kann bei einer Aktivierung nach einem Auszustand auf eine langsame Feuerrate im Einzelfeuer geschlossen werden.

In einer weiteren Ausführungsform ist das beschriebene Schussanalysesystem zur Integration eines Zeitstempels peripher mit einer Batterie und einer zusätzlichen Uhr ausgerüstet. So lassen sich zeitgenau alle mit dem Messsignal zusammenhängenden Aktivitäten im Schussanalysesystem nachweisen, insbesondere Datum und Uhrzeit, zu welchen die registrierten Schüsse stattgefunden haben. Durch die alleinige Verwendung einer Batterie ausschließlich für die Zeitmessung werden Batterien mit nur sehr geringen Kapazitäten und geringen Außenabmessungen benötigt, welche darüber hinaus noch nach Jahren oder sogar Jahrzenten für diese Realzeitmessung eine sichere Stromversorgung gewährleisten. Fällt eine solche Batterie aus, sind nach wie vor alle anderen beschriebenen Funktionen des Schussanalysesystems gewährleistet.

Bezugszeichenliste

| | |
|---|---|
| 100 | Schusswaffe |
| 110, 401 | Spannungserzeugungseinheit |
| 111,113, 301-312 | Permanentmagnete |
| 114 | Spule |
| 120 | Schlitten |
| 130 | Griffstück |
| U0 | Spannungswert |

| | |
|---|---|
| U1, U4 | erster Spannungsausschlag |
| U2, U5 | zweiter Spannungsausschlag |
| U3, U6 | dritter Spannungsausschlag |
| U01, U30, U04, U60 | kleinere Spannungsausschläge |
| t1, t2 | Zeitbereich |
| 321-323 | Zinke |
| 301-312 | Permanentmagnet |
| Ue | Wechselspannung |
| IN+ | Messspannung, Messsignal |
| Vin | Referenzspannung, Referenzsignal |
| Vcc | Versorgungsspannung |
| dIN+, dIN'+ | digitales Messignal |
| 410 | Signalverarbeitungseinheit |
| 450 | Zeitbestimmungseinheiten |
| 420 | Signalauswerteeinheit |
| 600 | Delon-Schaltung |
| D1, D2, D511, D512 | Diode |
| C1, C2, C511, C512 | Kondensator |
| 531, 533, 535 | Plot |
| 540 | Linearregler |
| Ua | gleichgerichtete Spannung |
| t70-t706, t711-t714 | Zeitpunkte |

**Patentansprüche**

1. Schusswaffenanalysevorrichtung zum Bestimmen eines Feuermodus einer mit einer Schusswaffe (7) geschossenen und zwei unmittelbar aufeinander folgende Schussabgaben umfassenden Schussfolge, umfassend

   eine Spannungserzeugungseinheit (401), die eingerichtet ist, während eines bei der Schussabgabe erfolgenden Vor- und/oder Rücklaufs eines beweglichen Waffenteils (120) der Schusswaffe (7) eine Wechselspannung ($U_e$) zu erzeugen;
   eine Signalverarbeitungseinheit (410), die eingerichtet ist, die Wechselspannung ($U_e$) in elektrische Energie für einen Energiespeicher umzuwandeln und die Energie im Energiespeicher zu speichern, sodass im Energiespeicher eine Mindestenergiemenge gespeichert wird, die beim Schießen im Dauerfeuer ausreicht, um eine Signalauswerteeinheit (420) während der zwei unmittelbar aufeinander folgenden Schussabgaben mit einer für den ordnungsgemäßen Betrieb der Signalauswerteeinheit (420) erforderlichen Mindestversorgungsspannung zu versorgen;
   einen Energiespeicher, der eingerichtet ist, elektrische Energie zu speichern und die Signalauswerteeinheit (420) mit der Mindestenergiemenge zu versorgen; und
   eine Signalauswerteeinheit (420), die eingerichtet ist, während den zwei unmittelbar aufeinander folgenden Schussabgaben

   in einem aktivierten Modus zu verbleiben, wenn sie vom Energiespeicher mit der Mindestversorgungspannung versorgt wird, und in einen nicht-aktivierten Modus zu wechseln, wenn sie vom Energiespeicher nicht mit der Mindestversorgungsspannung versorgt wird; und
   zu bestimmen, dass die Schussfolge im Dauerfeuer geschossen wurde, wenn sie während der zwei unmittelbar aufeinander folgenden Schussabgaben im aktivierten Modus geblieben ist, und, dass die Schussfolge im Einzelfeuer geschossen wurde, wenn sie während den zwei unmittelbar aufeinander folgenden Schussabgaben in den nicht-aktivierten Modus gewechselt hat.

2. Schusswaffenanalysevorrichtung nach Anspruch 1, deren Spannungserzeugungseinheit (401)

   wenigstens zwei magnetische Pole (113, 111); und
   eine Spule (114) umfasst;
   wobei die wenigstens zwei magnetischen Pole (113, 111) derart nacheinander angeordnet sind, dass sie sich in Reaktion auf die Schussabgabe auf einer Bahn relativ zur Spule (114) bewegen, wobei aufeinanderfolgende Pole jeweils zueinander entgegengesetzte Polarisierungen aufweisen, welche die Spule (114) derart nacheinander passieren, dass sie in der Spule (114) jeweils während des Rück- bzw. Vorlaufs die Wechselspannung induzieren.

3. Schusswaffenanalysevorrichtung nach Anspruch 1 oder 2, bei der der Energiespeicher ein Kondensator ist.

4. Schusswaffenanalysevorrichtung nach einem der vorhergehenden Ansprüche, bei der

im betriebsbereiten ersten Modus eine Taktquelle Takte erzeugt und ein Timer eine Anzahl der erzeugten Takte zählt; und
die Signalauswerteeinheit (420) die Anzahl der über einen Schusszyklus hinausgehenden Takte bestimmt.

5. Schusswaffenanalysevorrichtung nach dem vorhergehenden Anspruch, bei der die Signalauswerteeinheit (420) die bestimmte Anzahl der Takte in eine Zeit umrechnet.

6. Schusswaffenanalysevorrichtung nach einem der vorhergehenden Ansprüche, wobei die Signalauswerteeinheit (420) eingerichtet ist,

während einer Zeit in der die Wechselspannung ($U_e$) erzeugt wird in einen Auswerte-Modus für die Auswertung wenigstens eines aus der Wechselspannung ($U_e$) erzeugten Signals ($IN_+$; $Vi_n$) zu wechseln; und
mittels eines Registers zu bestimmen, ob der Wechsel in den Auswerte-Modus aus dem aktivierten Modus oder aus dem nicht-aktivierten Modus erfolgt ist.

7. Schusswaffenanalysevorrichtung nach einem der vorhergehenden Ansprüche, wobei die Signalauswerteeinheit eingerichtet ist, bei einem Wechsel vom nicht-aktivierten Modus in den aktivierten Modus einen Hardware-Reset durchzuführen.

8. Schusswaffenanalysevorrichtung nach einem der vorstehenden Ansprüche, deren Signalverarbeitungseinheit (410) eine Gleichrichterschaltung zum Gleichrichten von Spannungen umfasst, mit der sie zum Erzeugen der elektrischen Energie die Wechselspannung ($U_e$) gleichrichtet.

9. Schusswaffenanalysevorrichtung nach Anspruch 8, deren Gleichrichterschaltung eine Spannungsvervielfacherschaltung, insbesondere eine Delonschaltung (600) umfasst.

10. Schusswaffe umfassend eine Schusswaffenanalysevorrichtung nach einem der vorstehenden Ansprüche.

11. Verfahren zum Bestimmen eines Feuermodus einer mit einer Schusswaffe (7) geschossenen und zwei unmittelbar aufeinander folgende Schussabgaben umfassenden Schussfolge, umfassend:

Erzeugen einer Wechselspannung ($U_e$) während eines bei der Schussabgabe erfolgenden Vor- und/oder Rücklaufs eines beweglichen Waffenteils (120) der Schusswaffe (7) mittels einer Spannungserzeugungseinheit (401);
Umwandeln der Wechselspannung (Ue) in elektrische Energie für einen Energiespeicher mittels einer Signalverarbeitungseinheit (410);
Speichern der elektrischen Energie dem Energiespeicher, sodass in dem Energiespeicher eine Mindestenergiemenge gespeichert wird, die beim Schießen im Dauerfeuer ausreicht, um eine Signalauswerteeinheit (420) während der zwei unmittelbar aufeinander folgenden Schussabgaben mit einer für den ordnungsgemäßen Betrieb der Signalauswerteeinheit (420) erforderlichen Mindestversorgungsspannung zu versorgen,
Versorgen der Signalauswerteeinheit (420) mit der Mindestenergiemenge,
Konfigurieren der Signalauswerteeinheit (420) derart, dass sie den zwei unmittelbar aufeinander folgenden Schussabgaben in einem aktivierten Modus verbleibt, wenn sie vom Energiespeicher mit der Mindestver-sorgungsspannung versorgt wird, und in eine nicht-aktivierten Modus wechselt, wenn sie vom Energiespeicher nicht mit der Mindestversorgungsspannung versorgt wird, und
Bestimmen, dass die Schussfolge im Dauerfeuer geschossen wurde, wenn die Signalauswerteeinheit (420) während der zwei unmittelbar aufeinander folgenden Schussabgaben im aktivierten Modus geblieben ist, und dass die Schussfolge im Einzelfeuer-Feuermodus geschossen wurde, wenn sie während den zwei unmittelbar aufeinander folgenden Schussabgaben in den nicht-aktivierten Modus gewechselt hat.

12. Verfahren nach Anspruch 11, wobei das Umwandeln der Wechselspannung (Ue) in elektrische Energie ein Gleich-richten der Wechselspannung ($U_e$) umfasst, und das Speichern der elektrischen Energie mittels der gleichgerichteten

Wechselspannung (U$_e$) erfolgt.

13. Computerprogrammprodukt das Anweisungen zur Ausführung auf wenigstens einem Prozessor umfasst, die, wenn sie ausgeführt werden, den Prozessor veranlassen die Schritte wenigstens eines der Ansprüche 11 oder 12 auszuführen.

**Fig. 1**

Fig. 2a

Fig. 2b

Fig. 2c

FIG. 3a

FIG. 3b

## FIG. 3c

321

322

305   306   307   308

323

309   310   311   312

## FIG. 3d

321

301   302   303   304

322

305   306   307   308

323

FIG. 4

FIG. 5

401

Ue

531

410

C511

C512

D511

D512

533

Vin

540

Vcc

420

IN+

535

FIG. 6

FIG. 7

dIN+ =    1        0        1        0        1

dIN'+=    0        1        0        1        0

FIG. 8a

dIN+=10101

dIN+=0101

dIN+=101

FIG. 8b

dIN`+=01010

dIN`+=1010

dIN`+=010

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8046946 B2

- EP 3140605 B1